(19)

Europäisches
Patentamt
European
Patent Office
Office européen
des brevets

(11) **EP 4 782 847 A1**

(12) # EUROPEAN PATENT APPLICATION

(43) Date of publication:
**29.07.2026 Bulletin 2026/31**

(21) Application number: **25180400.1**

(22) Date of filing: **03.06.2025**

(51) International Patent Classification (IPC):
*G01R 15/18* (2006.01)    *G01R 15/20* (2006.01)

(52) Cooperative Patent Classification (CPC):
**G01R 15/185; G01R 15/205; G01R 15/207**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **27.01.2025 CN 202510125842**

(71) Applicant: **Southern Power Grid Sensing Technology**
**(Guangdong) Co., Ltd**
**Shenzhen, Guangdong 518102 (CN)**

(72) Inventors:
- **GAO, Ximing**
  **Shenzhen, Guangdong, 518102 (CN)**
- **LIU, Yuquan**
  **Shenzhen, Guangdong, 518102 (CN)**
- **TIAN, Bing**
  **Shenzhen, Guangdong, 518102 (CN)**
- **WANG, Zhiming**
  **Shenzhen, Guangdong, 518102 (CN)**
- **ZHAO, Jiguang**
  **Shenzhen, Guangdong, 518102 (CN)**
- **LUO, Wei**
  **Shenzhen, Guangdong, 518102 (CN)**
- **ZHAO, Liang**
  **Shenzhen, Guangdong, 518102 (CN)**

- **LV, Qiancheng**
  **Shenzhen, Guangdong, 518102 (CN)**
- **YANG, Hao**
  **Shenzhen, Guangdong, 518102 (CN)**
- **LUO, Baifeng**
  **Shenzhen, Guangdong, 518102 (CN)**
- **XU, Zhenheng**
  **Shenzhen, Guangdong, 518102 (CN)**
- **XU, Changbao**
  **Shenzhen, Guangdong, 518102 (CN)**
- **LIU, Zhong**
  **Shenzhen, Guangdong, 518102 (CN)**
- **FENG, Dong**
  **Shenzhen, Guangdong, 518102 (CN)**
- **XIN, Mingyong**
  **Shenzhen, Guangdong, 518102 (CN)**
- **JING, Maoheng**
  **Shenzhen, Guangdong, 518102 (CN)**
- **LI, Chun**
  **Shenzhen, Guangdong, 518102 (CN)**
- **YE, Zhenliang**
  **Shenzhen, Guangdong, 518102 (CN)**

(74) Representative: **Hoffmann Eitle**
**Patent- und Rechtsanwälte PartmbB**
**Arabellastraße 30**
**81925 München (DE)**

Remarks:
Amended claims in accordance with Rule 137(2) EPC.

(54) **CURRENT MEASUREMENT DEVICE AND METHOD**

(57)    The present invention provides a current measurement device. In the device, a first control circuit is connected to a broadband current measurement probe, a quantum current measurement probe includes a magnetic core, a coil provided on the magnetic core, a quantum current measurement member provided in an air gap of the magnetic core, the first control circuit is connected to the coil and the quantum current measurement member respectively; the broadband current measurement probe is configured to obtain a broadband current signal; the first control circuit is configured to determine a coil current value and a regulation microwave frequency according to the broadband current signal, circulate a coil current into the coil according to the coil current value, and control a microwave frequency at which the quantum current measurement member operates according to the regulation microwave frequency; the quantum current measurement member is configured to obtain a measured current value.

**EP 4 782 847 A1**

**(Cont. next page)**

FIG. 1

## Description

## TECHNICAL FIELD

The present application relates to the field of current measurement technology, particularly to a current measurement device and a current measurement method.

## BACKGROUND

With the accelerated construction of the novel power system, new energy has gradually become the main source of power supply, resulting in increasingly rich harmonic content in the power grid and a wider frequency range. Moreover, the backbone network of the power grid has taken on a new form of large-scale AC/DC hybrid connection, causing the current variation range in the power grid to change from milliampere level to hundreds of kiloampere level, and the frequency range to cover from the frequency of the direct current to hundreds of kilohertz of high-frequency alternating current.

When a current of an electrical device in the power grid is measured, a high-precision wide-range current measurement is the foundation for precise control of the power system. In the related technologies, the current measurement is widely performed by using transformers or fiber-optic current sensors. However, such a mode cannot meet the requirement of high-precision wide-range current measurement.

## SUMMARY

In view of this, in order to address the above technical problem, it is necessary to provide a current measurement device and method capable of satisfying the high-precision and wide-range current measurement requirements.

In the first aspect of the present invention, a current measurement device is provided, including a broadband current measurement probe, a quantum current measurement probe, and a first control circuit; the first control circuit being connected to the broadband current measurement probe, the quantum current measurement probe including a magnetic core, a coil provided on the magnetic core, and a quantum current measurement member provided in an air gap of the magnetic core, the first control circuit being further connected to the coil and the quantum current measurement member respectively. The broadband current measurement probe is configured to perform a current measurement on a to-be-measured conductor and obtain a broadband current signal; the first control circuit is configured to determine a coil current value and a regulation microwave frequency according to the broadband current signal, circulate a coil current into the coil according to the coil current value, and control a microwave frequency at which the quantum current measurement member operates according to the regulation microwave frequency; the quantum current measurement member is configured to perform a current measurement on the to-be-measured conductor and obtain a measured current value, wherein a magnetic field direction of a first magnetic field generated by the measured current at the air gap during the current measurement is opposite to a magnetic field direction of a second magnetic field generated by the coil current at the air gap.

In an embodiment, the first control circuit includes a coil control circuit and a frequency regulation circuit, the coil control circuit is connected to the broadband current measurement probe and the coil respectively, and the frequency regulation circuit is connected to the broadband current measurement probe and the quantum current measurement member respectively; the coil control circuit is configured to determine the coil current value according to the broadband current signal, and circulate the coil current into the coil according to the coil current value; the frequency regulation circuit is configured to determine to the regulation microwave frequency according to the broadband current signal, and control the microwave frequency at which the quantum current measurement member operates according to the regulation microwave frequency.

In an embodiment, the first control circuit further includes a conditioning circuit connected between the frequency regulation circuit and the quantum current measurement member; the conditioning circuit is configured to amplify the regulation microwave frequency, obtain an amplified regulation microwave frequency, and control the microwave frequency at which the quantum current measurement member operates according to the amplified regulation microwave frequency.

In an embodiment, the conditioning circuit includes a lock-in amplifier array, the lock-in amplifier array includes a plurality of lock-in amplifiers, a first switch, and a second switch; a fixed end of the first switch is connected to the frequency regulation circuit, a movable end of the first switch is configured to be connected to an input terminal of each lock-in amplifier, a movable end of the second switch is configured to be connected to an output terminal of each lock-in amplifier, and a fixed end of the second switch is connected to the quantum current measurement member.

In an embodiment, the first control circuit further includes a regulator circuit, one terminal of the regulator circuit is connected to the broadband current measurement probe, and the other terminal of the regulator circuit is connected to the coil control circuit and the frequency regulation circuit respectively; the regulator circuit is configured to perform a frequency regulation on the broadband current signal and obtain a frequency-regulated broadband current signal; the coil control circuit is configured to determine the coil current value according to the frequency-regulated broadband current signal; the frequency regulation circuit is configured to determine the regulation microwave frequency according to the frequency-regulated broadband current signal.

In an embodiment, the first control circuit further includes a current synthesis circuit which is connected to the coil control circuit and the conditioning circuit in the first control circuit respectively; the current synthesis circuit is configured to perform statistical processing on the coil current value and the measured current value, and obtain a target current value corresponding to the to-be-measured conductor.

In an embodiment, the current measurement device further includes a second control circuit, the second control circuit includes an energy supply circuit and a data processing circuit, both of which are connected to the first control circuit; the energy supply circuit is configured to supply power to the first control circuit; the data processing circuit is configured to acquire a target current value, and output a current according to the target current value, wherein the target current value is obtained by performing, via the first control circuit, statistical processing on the coil current value and the measured current value.

In the second aspect of the present invention, a current measurement method is provided, which can be applied to the current measurement device in the first aspect, the method includes: performing, by a broadband current measurement probe in a current measurement device, a current measurement on a to-be-measured conductor, and obtaining a broadband current signal; determining, by a first control circuit in the current measurement device, a coil current value and a regulation microwave frequency according to the broadband current signal, circulating a coil current into a coil according to the coil current value, and controlling a microwave frequency at which a quantum current measurement member operates according to the regulation microwave frequency; and performing, by the quantum current measurement member in the current measurement device, a current measurement on the to-be-measured conductor to obtain a measured current value, wherein a magnetic field direction of a first magnetic field generated by the measured current at an air gap during the current measurement is opposite to a magnetic field direction of a second magnetic field generated by the coil current at an air gap.

In an embodiment, determining the coil current value and the regulation microwave frequency according to the broadband current signal, circulating the coil current into the coil according to the coil current value, and controlling the microwave frequency at which the quantum current measurement member operates according to the regulation microwave frequency includes: determining, by the coil control circuit in the first control circuit, the coil current value according to the broadband current signal, and circulating the coil current into the coil according to the coil current value; and determining, by the frequency regulation circuit in the first control circuit, the regulation microwave frequency according to the broadband current signal, and controlling the microwave frequency at which the quantum current measurement member operates according to the regulation microwave frequency.

In an embodiment, controlling the microwave frequency at which the quantum current measurement member operates according to the regulation microwave frequency includes: performing, by a conditioning circuit in the first control circuit, amplification processing on the regulation microwave frequency to obtain an amplified regulation microwave frequency, and controlling the microwave frequency at which the quantum current measurement member operates according to the amplified regulation microwave frequency.

In an embodiment, determining the coil current value and the regulation microwave frequency according to the broadband current signal, circulating the coil current into the coil according to the coil current value, and controlling the microwave frequency at which the quantum current measurement member operates according to the regulation microwave frequency includes: performing, by a regulator circuit in the first control circuit, a frequency regulation on the broadband current signal, and obtaining a frequency-regulated broadband current signal; determining, by the coil control circuit, the coil current value according to the frequency-regulated broadband current signal; and determining, by the frequency regulation circuit, the regulation microwave frequency according to the frequency-regulated broadband current signal.

In an embodiment, the method further includes: performing, by a current synthesis circuit in the first control circuit, statistical processing on the coil current value and the measured current value, and obtaining the target current value corresponding to the to-be-measured conductor.

In the above current measurement device and method, the current measurement device includes the broadband current measurement probe, the quantum current measurement probe, and the first control circuit. The first control circuit is connected to the broadband current measurement probe. The quantum current measurement probe includes the magnetic core, the coil provided on the magnetic core, and the quantum current measurement member provided in the air gap of the magnetic core. The first control circuit is further connected to the coil and the quantum current measurement member respectively. The to-be-measured conductor may be arranged inside the broadband current measurement probe and the quantum current measurement probe. When the to-be-measured conductor is energized, the broadband current measurement probe performs the current measurement on the to-be-measured conductor, and the broadband current signal can be obtained, so that the measured frequency range is improved. Subsequently, the first control circuit determines the coil current value and the regulation microwave frequency according to the broadband current signal, circulates the coil current into the coil according to the coil current value, and controls the microwave frequency at which the quantum current measurement member operates according to the regulation microwave frequency, so that the quantum current measurement member performs the current measurement on the to-be-measured conductor and obtains the measured current value. Since the magnetic field direction of the first magnetic field generated by the measured current at the air gap during the current measurement is opposite to the magnetic field direction of the second magnetic field generated by the coil current at the air gap, the magnetic field at the air gap is near the zero point, that is, the magnetic induction intensity at the air gap approaches to zero. Accordingly, the measured current signal weakens, the measurement range of the current measured by the quantum current measurement member is reduced, and the precision of the measured current value is improved, thereby implementing the high-precision and wide-range current measurement requirements.

## BRIEF DESCRIPTION OF THE DRAWINGS

In order to describe the technical solution in the embodiments of the present invention or the related technologies more clearly, the accompanying drawings required for describing the embodiments of the present invention or the related technologies will be briefly introduced below. Obviously, the accompanying drawings in the following description show merely some embodiments of the present invention, and a person of ordinary skill in the art may still obtain other related drawings according to these accompanying drawings without creative efforts.

FIG. 1 is a schematic diagram illustrating a current measurement device according to an embodiment.
FIG. 2 is a schematic diagram illustrating a current measurement device according to another embodiment.
FIG. 3 is a schematic diagram illustrating a current measurement device according to another embodiment.
FIG. 4 is a schematic diagram illustrating a lock-in amplifier array according to an embodiment.
FIG. 5 is a schematic diagram illustrating a current measurement device according to another embodiment.
FIG. 6 is a schematic diagram illustrating a current measurement device according to another embodiment.
FIG. 7 is a schematic diagram illustrating a current measurement device according to another embodiment.
FIG. 8 is a flow chart showing a current measurement method according to an embodiment.
FIG. 9 is a flow chart of step S802 according to an embodiment.
FIG. 10 is a flow chart of step S802 according to another embodiment.

## DETAILED DESCRIPTION

In order to make the purposes, technical solution, and advantages of the present invention clearer, the present invention will be elaborated with reference to the accompanying drawings and embodiments. It should be appreciated that the specific embodiments described herein are merely used for explaining the present invention, rather than limiting the present invention.

With the accelerated construction of the novel power system, new energy has gradually become the main source of power supply, resulting in increasingly rich harmonic content in the power grid and a wider frequency range. Moreover, the backbone network of the power grid has taken on a new form of large-scale AC/DC hybrid connection, causing the current variation range in the power grid to change from milliampere level to hundreds of kiloampere level, and a frequency range covering dozens of hertz to hundreds of kilohertz. However, the change range and frequency range of current in the power grid are relatively large, which may affect the accuracy of the current measurement. Accordingly, when a current of an electrical device in the power grid is measured, a high-precision and wide-range current measurement is the foundation of precise control of the power system.

At present, the current measurement in the power system is widely performed by using transformers or fiber-optic current sensors. The transformers are only adapted to measuring the AC current but cannot measure the DC current and high-frequency harmonics. The fiber-optic current sensors are greatly affected by temperature and have low reliability. Accordingly, the measurement accuracies of these measurement means are difficult to satisfy the high-precision and wide-range measurement requirements of the power system.

In view of this, the present invention provides a current measurement device, to satisfy the high-precision and wide-range current measurement requirements.

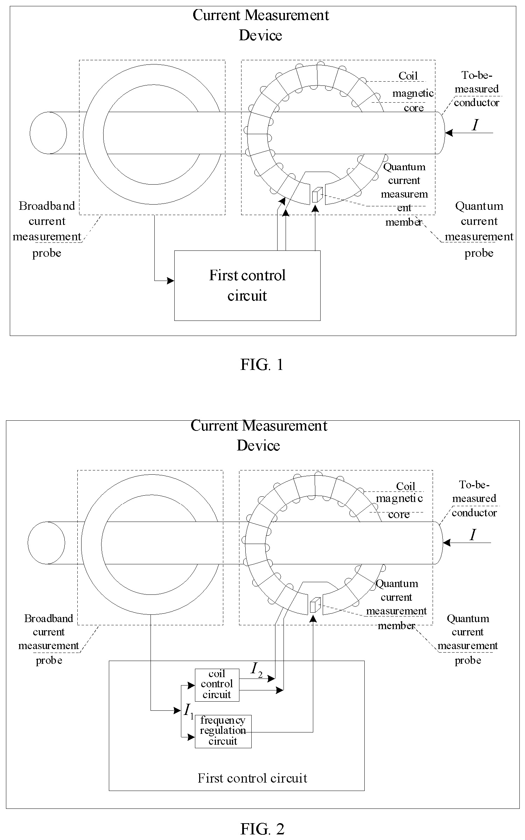

In an exemplary embodiment, as shown in FIG. 1, a current measurement device is provided, including a broadband current measurement probe, a quantum current measurement probe, and a first control circuit. The first control circuit is connected to the broadband current measurement probe. The quantum current measurement probe includes a magnetic core, a coil provided on the magnetic core, and a quantum current measurement member provided in an air gap of the magnetic core. The first control circuit is further connected to the coil and the quantum current measurement member respectively. The broadband current measurement probe is configured to perform a current measurement on a to-be-measured conductor and obtain a broadband current signal. The first control circuit is configured to determine a coil current value and a regulation microwave frequency according to the broadband current signal, circulate a coil current into the coil according to the coil current value, and control a microwave frequency at which the quantum current measurement member operates according to the regulation microwave frequency. The quantum current measurement member is configured to perform the current measurement on the to-be-measured conductor and obtain a measured current value, in which a magnetic field direction of a first magnetic field generated by the measured current at the air gap during the current measurement is opposite to a magnetic field direction of a second magnetic field generated by the coil current at the air gap.

It should be noted that, when the high-precision and wide-range current measurement requirements are met, the current measurement device needs to meet a wider frequency range for measurement and a requirement for a higher precision in the current measurement. Accordingly, in the current measurement device provided in the embodiment of the present invention, an advantage of a high measurement precision of the quantum current sensor and a characteristic of a higher response speed of a Tunneling Magnetoresistance (TMR) sensor are used, the measurement precision and the measurement frequency range are improved, thereby meeting the high-precision and wide-range current measurement requirements.

The broadband current measurement probe usually includes a Hall effect sensor, a preamplifier, and an output terminal. The broadband current measurement probe is made of a magnetic semiconductor material. When a current passes through, a magnetic field is generated in the broadband current measurement probe, to excite a charge in a Hall ring, and a voltage signal is generated at the output terminal. The voltage signal is transmitted to the preamplifier for amplification and processing, and finally, a measurable electrical signal is output. The broadband current measurement probe can measure both AC and DC currents simultaneously. The broadband refers to a wide frequency range that a probe can measure, and generally refers to a measurement range from a DC frequency to a higher AC frequency (such as 120MHz).

In the embodiment, the broadband current measurement probe may be a circular ring, and is provided around the to-be-measured conductor and configured to measure a broadband current signal corresponding to the to-be-measured conductor. The broadband current signal is an electrical signal proportional to a to-be-measured current corresponding to the to-be-measured conductor, and a frequency range of the broadband current signal is far higher than a frequency range of a current signal measured by the quantum current measurement probe.

The quantum current measurement probe is a sensor that implements the high-precision current measurement by using a quantum effect. The quantum current measurement probe may be a circular ring, and is provided around the to-be-measured conductor. The quantum current measurement probe is made of a ferromagnetic semiconductor material, and can perform the current measurement by using a quantum tunnel effect, and has advantages of high precision, wide measurement range, low power consumption, and high sensitivity, etc. The quantum current measurement probe may include a magnetic core, a coil provided on the magnetic core, and a quantum current measurement member provided in an air gap of the magnetic core. The coil refers to an energized wire wound around the magnetic core, and each turn of the coil is mutually insulated. When the magnetic core is arranged inside the energized coil, a magnetic field generated by the coil can be significantly enhanced, and a magnetic field generated by the magnetic core itself is superimposed on a magnetic field generated by the energized coil to further enhance the magnetism. Accordingly, in a case in which a magnetic field is generated after the coil is energized, the magnetic field can be better aggregated and transmitted through the magnetic core, so that the magnetic field is more concentrated, thereby reducing diffusion and loss of the magnetic field, increasing an inductance of the coil, and reducing electromagnetic wave interference. The quantum current measurement member is a sensor that performs the current measurement by using a quantum technology. The quantum current measurement member utilizes unique quantum properties inside a diamond, and can perform the high-precision current measurement under the strong magnetic and high voltage environment of the power grid. Accordingly, a non-contact current measurement is implemented by detecting the magnetic field generated by the current, the measurement range can be from 1mA to 10kA, and the precision reaches six ten thousandths.

It should be appreciated that an air gap is provided in the magnetic core, which can reduce a magnetic hysteresis and a vortex loss in the magnetic core, and improve a magnetic permeability and a saturation magnetic induction intensity of the magnetic core. Accordingly, in the embodiment, the magnetic core may be a magnetic core including an air gap, and the quantum current measurement member is provided in the air gap.

It should be noted that, when the to-be-measured conductor is energized, a magnetic induction intensity of a magnetic field generated is directly proportional to a magnitude of the current. However, in order to improve the measurement accuracy of the current, a measurement range of the measured current needs to be reduced. Therefore, a magnetic field with a magnetic direction opposite to the magnetic field generated when the to-be-measured conductor is energized, may be superimposed on the magnetic field generated when the to-be-measured conductor is energized, to reduce the measurement range of the measured current and improve the measurement accuracy of the current. In the embodiment, the magnetic field generated by the measured current at the air gap in the current measurement process is determined as a first magnetic field.

The first control circuit is configured to control a measurement process of the quantum current measurement probe according to the broadband current signal measured by the broadband current measurement probe. In the embodiment, the first control circuit may acquire the broadband current signal by connecting the broadband current measurement probe, and then determine a coil current value applied to the coil according to the broadband current signal, determine, according to the broadband current signal, a regulation microwave frequency configured to control a microwave frequency at which the quantum current measurement member operates, apply the coil current value to the coil by connecting the coil, and output the regulation microwave frequency to the quantum current measurement member by connecting the quantum current measurement member.

The coil current value may cause the coil to generate the magnetic field. In the embodiment, when the coil current value is applied to the coil, a magnetic field generated by the coil current at the air gap may be determined as a second magnetic field. In order to improve the measurement precision, a magnetic field direction of the first magnetic field generated by the measured current at the air gap in the current measurement process is opposite to a magnetic field direction of the second magnetic field generated by the coil current at the air gap. Accordingly, a magnetic susceptibility direction of the quantum current measurement member is perpendicular to a section of the air gap of the magnetic core.

The regulation microwave frequency is configured to control a microwave frequency at which the quantum current measurement member operates. The microwave frequency is a superimposed frequency when the quantum current measurement member measures a current of the to-be-measured conductor which is energized. It should be appreciated that, when the current is measured based on the unique quantum properties of the diamond of the quantum current measurement member, a spectrum corresponding to the diamond may be changed by superimposing a frequency, so that the magnetic induction intensity related to the current is determined according to the spectrum characteristic, and then the measured current corresponding to the to-be-measured conductor is obtained.

In the embodiment, the broadband current measurement probe and the quantum current measurement probe may be provided around the to-be-measured conductor respectively. In a case in which the to-be-measured conductor is energized, the broadband current signal is measured by the broadband current measurement probe, the coil current value and the regulation microwave frequency are determined by the first control circuit according to the broadband current signal, the coil current is circulated into the coil according to the coil current value, the microwave frequency at which the quantum current measurement member operates is controlled according to the regulation microwave frequency, and accordingly the quantum current measurement member measures the current of the to-be-measured conductor and obtains the measured current value. The magnetic field direction of the first magnetic field generated by the measured current at the air gap in the current measurement process is opposite to the magnetic field direction of the second magnetic field generated by the coil current at the air gap.

The above-mentioned current measurement device includes a broadband current measurement probe, a quantum current measurement probe, and a first control circuit. The first control circuit is connected to the broadband current measurement probe. The quantum current measurement probe includes a magnetic core, a coil provided on the magnetic core, and a quantum current measurement member provided in an air gap of the magnetic core. The first control circuit is further connected to the coil and the quantum current measurement member respectively. A to-be-measured conductor can be provided inside the broadband current measurement probe and the quantum current measurement probe. When the to-be-measured conductor is energized, a current of the to-be-measured conductor is measured by the broadband current measurement probe, and a broadband current signal can be obtained, so that a frequency range of the measurement can be improved. Furthermore, a coil current value and a regulation microwave frequency are determined by the first control circuit according to the broadband current signal, a coil current is circulated into the coil according to the coil current value, and a microwave frequency at which the quantum current measurement member operates is controlled according to the regulation microwave frequency, thus the quantum current measurement member measures the current of the to-be-measured conductor and obtains the measured current value. Since the magnetic field direction of the first magnetic field generated by the measured current at the air gap in the current measurement process is opposite to the magnetic field direction of the second magnetic field generated by the coil current at the air gap, the magnetic field at the air gap is near the zero point, that is, the magnetic induction intensity at the air gap approaches to zero. Accordingly, the measured current signal weakens, the measurement range of the current measured by the quantum current measurement member is reduced, and the precision of the measured current value is improved, thereby implementing the high-precision and wide-range current measurement requirements.

Based on the FIG. 1, in an exemplary embodiment, as shown in FIG. 2, the first control circuit includes a coil control circuit and a frequency regulation circuit. The coil control circuit is connected to the broadband current measurement probe and the coil respectively, and the frequency regulation circuit is connected to the broadband current measurement probe and the quantum current measurement member respectively. The coil control circuit is configured to determine a coil current value according to a broadband current signal, and circulate a coil current into the coil according to the coil current value. The frequency regulation circuit is configured to determine to a regulation microwave frequency according to the broadband current signal, and control a microwave frequency at which the quantum current measurement member operates according to the regulation microwave frequency.

The coil control circuit is configured to determine the coil current value according to the broadband current signal. A process of determining the coil current value may be represented as follows:

$$I_2 = k \cdot \frac{1}{N} \cdot I_1 \ ;$$

where $I_1$ denotes a broadband current signal, $I_2$ denotes a coil current value, $N$ denotes turns per coil, $k$ denotes a set coefficient, satisfying $0 < k \leq 1$. When $k = 1$, the second magnetic field generated by the coil current at the air gap is near a zero point.

The frequency regulation circuit is configured to determine a regulation microwave frequency inputted into the quantum current measurement member according to the broadband current signal, to regulate a microwave frequency at which the quantum current measurement member operates in a process of measuring a current by the quantum current measurement member. It should be appreciated that the regulation microwave frequency is the closest frequency at which the quantum current measurement member can obtain a target frequency of the measured current value according to the first magnetic field. For example, if the target frequency of the measured current value obtained according to the first magnetic field is 50HZ, the regulation microwave frequency may be 49.8HZ, or the regulation microwave frequency may be 50.4HZ. It should be appreciated that a frequency regulation circuit can quickly determine the regulation microwave frequency, so that the quantum current measurement member can quickly measure the measured current value of the to-be-measured conductor when the to-be-measured conductor is energized, thereby improving the measurement accuracy and precision of the measured current value.

In the embodiment, the coil control circuit is connected to the broadband current measurement probe, and may receive the broadband current signal, and determine the coil current value according to a current regulation formula. Subsequently, the coil control circuit is connected to the coil, and the coil current is circulated into the coil according to the coil current value. The frequency regulation circuit is connected to the broadband current measurement probe, and may receive the broadband current signal, perform a frequency analysis on the broadband current signal, and then determine the regulation microwave frequency from a result of the frequency analysis according to a preset frequency. Subsequently, the frequency regulation circuit is connected to the quantum current measurement member, and outputs the regulation microwave frequency to the quantum current measurement member, to control the microwave frequency at which the quantum current measurement member operates according to the regulation microwave frequency.

In the embodiment, the first control circuit includes the coil control circuit and the frequency regulation circuit. The coil control circuit is connected to the broadband current measurement probe and the coil respectively, and the frequency regulation circuit is connected to the broadband current measurement probe and the quantum current measurement member respectively. The coil control circuit may determine the coil current value according to the broadband current signal, and circulate the coil current into the coil according to the coil current value. The frequency regulation circuit determines the regulation microwave frequency according to the broadband current signal, and controls the microwave frequency at which the quantum current measurement member operates according to the regulation microwave frequency. Accordingly, the magnetic field direction of the first magnetic field generated by the measured current at the air gap is opposite to the magnetic field direction of the second magnetic field generated by the coil current at the air gap, thereby improving the precision of the measured current value obtained by the quantum current measurement member.

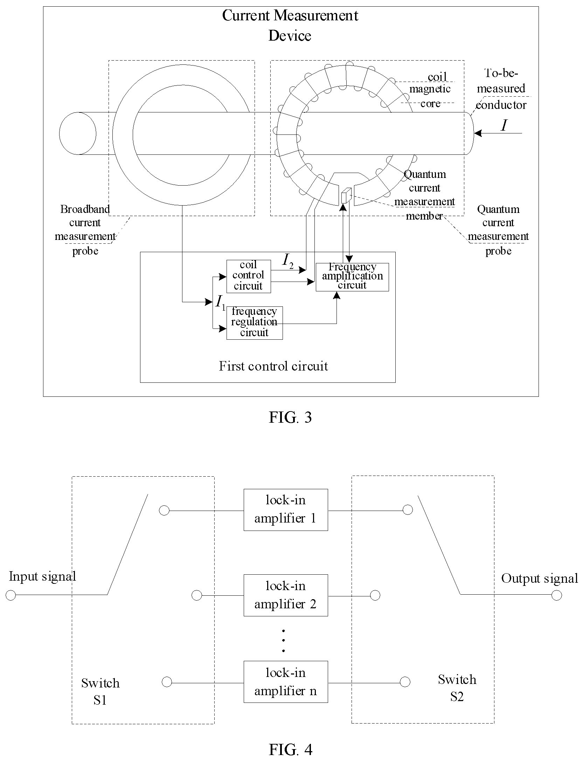

Based on the FIG. 2, in an exemplary embodiment, as shown in FIG. 3, the first control circuit further includes a conditioning circuit connected between the frequency regulation circuit and the quantum current measurement member. The conditioning circuit is configured to amplify the regulation microwave frequency, obtain an amplified regulation microwave frequency, and control the microwave frequency at which the quantum current measurement member operates according to the amplified regulation microwave frequency.

The conditioning circuit is configured to amplify an inputted signal, and perform conversion on the amplified signal. In the embodiment, the conditioning circuit may convert an inputted frequency signal into a microwave signal and transmit the microwave signal, and detect a fluorescence signal transmitted by the diamond in the quantum current measurement member. It should be noted that, in a signal transmission process, a signal strength decreases due to various types of interferences and attenuations. Accordingly, in the embodiment, the conditioning circuit amplifies the regulation microwave frequency, converts the amplified regulation microwave frequency signal into the microwave signal, and transmits the microwave signal to the quantum current measurement member.

In a feasible embodiment, as shown in FIG. 4, the conditioning circuit includes a lock-in amplifier array. The lock-in amplifier array includes a plurality of lock-in amplifiers, a first switch, and a second switch. A fixed end of the first switch is connected to the frequency regulation circuit, a movable end of the first switch is configured to be connected to an input terminal of each lock-in amplifier. A movable end of the second switch is configured to be connected to an output terminal of each lock-in amplifier, and a fixed end of the second switch is connected to the quantum current measurement member.

The lock-in amplifier is a device configured to detect a weak signal, and perform noise filtering on the weak signal before performing signal amplification processing on the weak signal. Accordingly, in a high-noise environment, a reference signal having the same frequency and phase relationship as the detected signal serves as a benchmark, and the lock-in amplifier only responds to the detected signal itself and the signal having the same frequency and noise components as the reference signal, so that the signal of specific frequency is effectively separated out. The lock-in amplifier regulates a phase of a local oscillator signal by comparing the input signal to the local oscillator signal, to ensure the phase of the local oscillator signal to be consistent with the phase of the input signal, thereby forming a lock-in state. The input signal is converted into a DC interval by mixing the input signal with the local oscillator signal, and then a high-frequency component is filtered through a low-pass filter to finally obtain a signal directly proportional to the input signal.

In the embodiment, the plurality of lock-in amplifiers are employed to form the lock-in amplifier array, and the first switch and the second switch are provided in the lock-in amplifier array. The first switch is configured to switch among the plurality of lock-in amplifiers at an input signal terminal of the lock-in amplifier array, and the second switch is configured to switch among the plurality of lock-in amplifiers at an output signal terminal of the lock-in amplifier array, so that a signal extraction speed can be improved while the signal processing method is performed on the regulation microwave frequency.

In the embodiment, the conditioning circuit in the first control circuit is connected to the frequency regulation circuit. The lock-in amplifier array in the conditioning circuit can amplify the regulation microwave frequency, the conditioning circuit is connected to the quantum current measurement member to transmit the amplified regulation microwave frequency to the quantum current measurement member, so that the microwave frequency at which the quantum current measurement member operates is controlled according to the amplified regulation microwave frequency. Further, after obtaining the measured current value corresponding to the to-be-measured conductor, the quantum current measurement member may further transmit the measured current value to the conditioning circuit.

In the embodiment, the first control circuit further includes the conditioning circuit connected between the frequency regulation circuit and the quantum current measurement member. The conditioning circuit is configured to perform amplification processing and conversion processing on the regulation microwave frequency, obtain a converted regulation microwave frequency, and control the microwave frequency at which the quantum current measurement member operates according to the converted regulation microwave frequency. Since the regulation microwave frequency output by the frequency regulation circuit can be amplified, the problem that the signal strength weakens due to interference and attenuation of the regulation microwave frequency during the transmission is avoided. In addition, the amplified regulation microwave frequency signal is converted into the microwave signal, thereby ensuring the reliability of the regulation microwave frequency output to the quantum current measurement member, and further improving the precision of the measured current obtained by the quantum current measurement member.

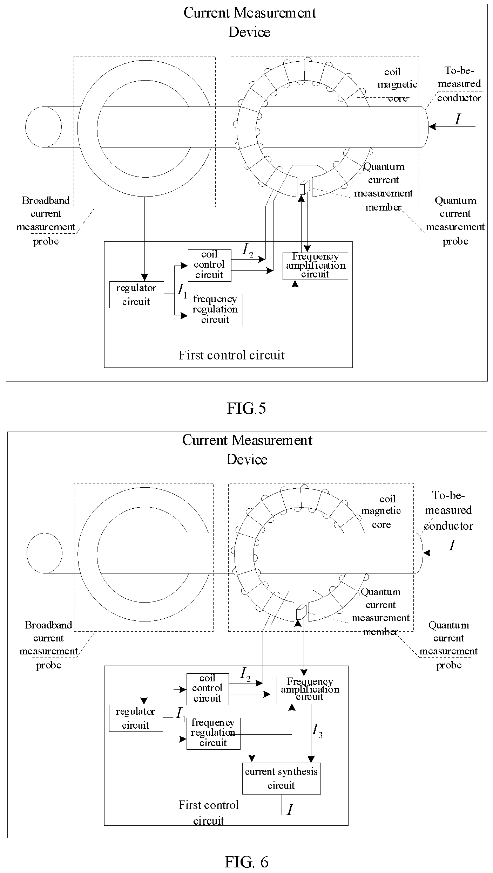

Based on the FIG. 3, in an exemplary embodiment, as shown in FIG. 5, the first control circuit further includes a regulator circuit. One terminal of the regulator circuit is connected to the broadband current measurement probe, and the other terminal of the regulator circuit is connected to the coil control circuit and the frequency regulation circuit respectively. The regulator circuit is configured to perform a frequency regulation on the broadband current signal and obtain a frequency-regulated broadband current signal. The coil control circuit is configured to determine a coil current value according to the frequency-regulated broadband current signal. The frequency regulation circuit is configured to determine the regulation microwave frequency according to the frequency-regulated broadband current signal.

The regulator circuit is configured to reduce a frequency of a broadband current signal to match a frequency range of a current measurement of the quantum current measurement member. It should be noted that a frequency of a current refers to the number of times an electric field or a magnetic field changes per second, and is generally used for describing a change frequency of an alternating current. Reducing of the frequency of the current means that the number of times the alternating current changes within a unit of time decreases, so that a waveform of the current becomes smoother and the frequency decreases.

In the embodiment, one terminal of the regulator circuit in the first control circuit is connected to the broadband current measurement probe to obtain the broadband current signal, and performs the frequency regulation on the broadband current signal to obtain the frequency-regulated broadband current signal. Subsequently, the other terminal of the regulator circuit is connected to the coil control circuit and the frequency regulation circuit respectively, and transmits the frequency-regulated broadband current signal to the coil control circuit and the frequency regulation circuit respectively. After that, the coil control circuit may be specifically configured to determine the coil current value according to the frequency-regulated broadband current signal, and the frequency regulation circuit may be specifically configured to determine the regulation microwave frequency according to the frequency-regulated broadband current signal.

In the embodiment, the first control circuit further includes the regulator circuit. One terminal of the regulator circuit is connected to the broadband current measurement probe, and the other terminal of the regulator circuit is connected to the coil control circuit and the frequency regulation circuit respectively. One terminal of the regulator circuit is connected to the broadband current measurement probe to obtain the broadband current signal, and performs the frequency regulation on the broadband current signal to obtain the frequency-regulated broadband current signal, to reduce a frequency corresponding to the broadband current signal. Subsequently, the other terminal of the regulator circuit is connected to the coil control circuit and the frequency regulation circuit respectively, the frequency-regulated broadband current signal can be transmitted to the coil control circuit and the frequency regulation circuit respectively, so that the coil control circuit may be specifically configured to determine the coil current value according to the frequency-regulated broadband current signal, and the frequency regulation circuit may be specifically configured to determine the regulation microwave frequency according to the frequency-regulated broadband current signal. Accordingly, since the frequency-regulated broadband current signal can match a measurable frequency range of the quantum current measurement member, the precisions of the determined coil current value and regulation microwave frequency can be improved, and the precision of the measured current value obtained by the quantum current measurement member can be further improved.

Based on the FIG. 5, in an exemplary embodiment, as shown in FIG. 6, the first control circuit further includes a current synthesis circuit which is connected to the coil control circuit and the conditioning circuit in the first control circuit respectively. The current synthesis circuit is configured to perform statistical processing on the coil current value and the measured current value and obtain a target current value corresponding to the to-be-measured conductor.

The current synthesis circuit is configured to combine current signals. It should be appreciated that, since the measured current value obtained by the quantum current measurement member is measured after the second magnetic field generated by the coil current is superimposed on the first magnetic field generated by the measured current, the measured current value can be regulated according to the coil current value.

In the embodiment, the current synthesis circuit in the first control circuit is connected to the coil control circuit, and can acquire the coil current value. In addition, the current synthesis circuit is connected to the conditioning circuit, and can acquire the measured current value. Subsequently, the coil current value and the measured current value can be combined, and a target current value corresponding to the to-be-measured conductor is obtained. The target current value may be represented as follows:

$$I = N \cdot I_2 + I_3 \ ;$$

where $I$ denotes the target current value, $N$ denotes turns per coil, $I_2$ denotes the coil current value, and $I_3$ denotes the measured current value.

In the embodiment, the first control circuit further includes the current synthesis circuit. The current synthesis circuit is connected to the coil control circuit and the conditioning circuit in the first control circuit respectively. The current synthesis circuit is connected to the coil control circuit, and can acquire the coil current value. The current synthesis circuit is connected to the conditioning circuit, and can acquire the measured current value. Subsequently, the statistical processing is performed on the coil current value and the measured current value, the target current value corresponding to the to-be-measured conductor can be obtained. Since the measured current value is regulated according to the coil current value, an effect of the superimposing of the magnetic field generated by the coil current and the magnetic field generated by the measured current during obtaining the measured current value can be eliminated, thereby improving the precision of the obtained target current value corresponding to the to-be-measured conductor.

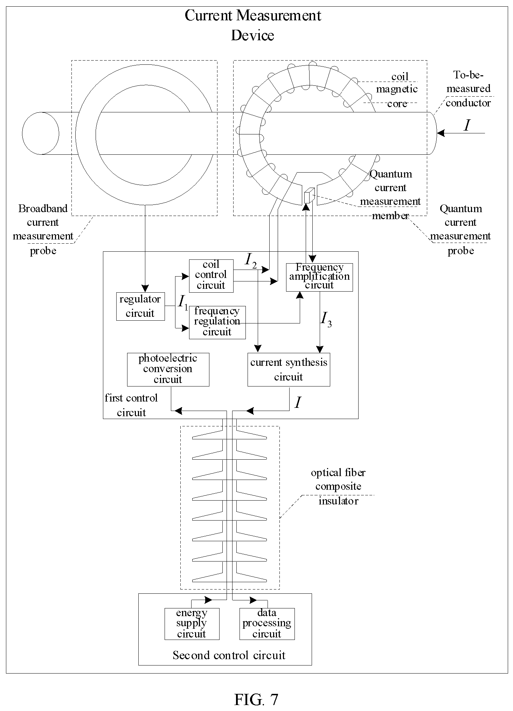

Based on the FIG. 6, in an exemplary embodiment, as shown in FIG. 7, the current measurement device further includes a second control circuit. The second control circuit includes an energy supply circuit and a data processing circuit, both of which are connected to the first control circuit. The energy supply circuit is configured to supply power to the first control circuit. The data processing circuit is configured to acquire a target current value, and output a current according to the target current value. The target current value is obtained by performing, via the first control circuit, the statistical processing on the coil current value and the measured current value.

The second control circuit corresponds to the first control circuit, supplies power to the first control circuit, and acquires the target current value output by the first control circuit. The target current value is obtained by performing, via the first control circuit, the statistical processing on the coil current value and the measured current value. In the scenario where the current value of the power grid is measured by the current measurement device provided in the embodiment of the present invention, the first control circuit may be provided on a high-voltage side, and the second control circuit may be provided on a low-voltage side.

The energy supply circuit may be a laser energy supply circuit, configured to receive a laser signal, and transmit the laser signal to the first control circuit by connecting to the first control circuit, in order to supply power to the first control circuit. The data processing circuit may receive, by connecting to the first control circuit, the target current value obtained by the first control circuit, and output the current according to the target current value.

In feasible embodiment, the current measurement device may further include an optical fiber composite insulator. The optical fiber composite insulator is a new-type insulating material combining a composite material technology and an optical fiber technology, and is a high-strength, high-insulation performance, and high-signal transmission capability insulator formed by means of hot press molding after the optical fiber and the composite material are mixed. The first control circuit can be connected to the energy supply circuit and the data processing circuit respectively through the optical fiber composite insulator.

The first control circuit may further include a photoelectric conversion circuit and a current synthesis circuit. Specifically, the photoelectric conversion circuit in the first control circuit may be connected to the energy supply circuit in the second control circuit through an optical fiber composite insulator, and the current synthesis circuit in the first control circuit may be connected to the data processing circuit in the second control circuit through an optical fiber composite insulator.

Optionally, the data processing circuit may further be connected to an external electrical device, and output the target current value to the external electrical device.

In the embodiment, the energy supply circuit and the data processing circuit included in the second control circuit are both connected to the first control circuit. The energy supply circuit may supply power to the first control circuit, and the data processing circuit may acquire the target current value from the first control circuit, and output the current according to the target current value.

In the embodiment, the current measurement device further includes a second control circuit. The second control circuit includes the energy supply circuit and the data processing circuit. Both the energy supply circuit and the data processing circuit are connected to the first control circuit. The energy supply circuit can supply power to the first control circuit, so that the first control circuit can determine a target current value of the to-be-measured conductor according to the broadband current signal measured by the broadband current measurement probe and the measured current value output by the quantum current measurement probe, so that the data processing circuit can acquire the target current value and output the current according to the target current value. Since the precision of the target current value determined by the first control circuit is higher, the accuracy of the output current can be improved.

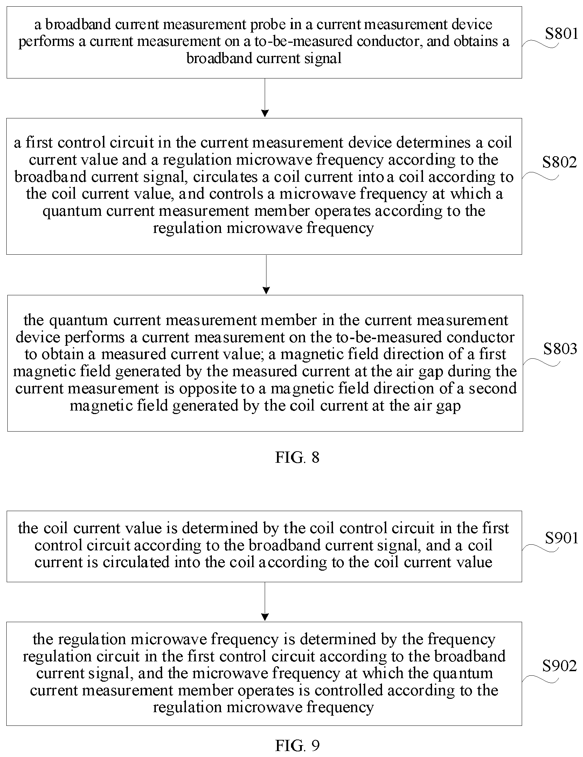

Based on the above embodiment, in an exemplary embodiment of the present invention, a current measurement method is provided. The current measurement method can be applied to the above-mentioned current measurement device. As shown in FIG. 8, the current measurement method may include following steps S801 to S803.

S801: a broadband current measurement probe in a current measurement device performs a current measurement on a to-be-measured conductor, and obtains a broadband current signal.

The broadband current signal is an electrical signal that is directly proportional to a to-be-measured current corresponding to the to-be-measured conductor, and a frequency range of the broadband current signal is much larger than a frequency range of a current signal measured by a quantum current measurement probe.

In the embodiment, after the to-be-measured conductor is energized, a magnetic field may be generated. The current measurement device may obtain the broadband current signal according to the magnetic field by means of the broadband current measurement probe.

S802: a first control circuit in the current measurement device determines a coil current value and a regulation microwave frequency according to the broadband current signal, circulates a coil current into a coil according to the coil current value, and controls a microwave frequency at which a quantum current measurement member operates according to the regulation microwave frequency.

The first control circuit is configured to control a measurement process of the quantum current measurement probe according to the broadband current signal measured by the broadband current measurement probe.

In the embodiment, the current measurement device may acquire the broadband current signal from the broadband current measurement probe through the first control circuit, so that the coil current value into the coil is determined according to the broadband current signal, and a regulation microwave frequency for controlling a microwave frequency at which the quantum current measurement member operates is determined according to the broadband current signal.

S803: the quantum current measurement member in the current measurement device performs a current measurement on the to-be-measured conductor to obtain a measured current value; a magnetic field direction of a first magnetic field generated by the measured current at the air gap during the current measurement is opposite to a magnetic field direction of a second magnetic field generated by the coil current at the air gap.

The quantum current measurement member is a sensor that implements the high-precision current measurement by using a quantum effect.

In the embodiment, the current measurement device may acquire the coil current value and the regulation microwave frequency from the first control circuit by means of the quantum current measurement member, and then in the current measurement process, obtain the measured current value corresponding to the to-be-measured conductor according to the first magnetic field generated by the measured current during the current measurement and the second magnetic field generated by the coil current at the air gap.

In a feasible embodiment, the current synthesis circuit in the first control circuit may perform statistical processing on the coil current value and the measured current value and obtain the target current value corresponding to the to-be-measured conductor.

In the embodiment, the to-be-measured conductor may be arranged inside the broadband current measurement probe and the quantum current measurement probe. When the to-be-measured conductor is energized, the current measurement device performs the current measurement on the to-be-measured conductor via the broadband current measurement probe, so that the broadband current signal can be obtained, and the measured frequency range can be improved. Subsequently, the first control circuit determines the coil current value and the regulation microwave frequency according to the broadband current signal, circulates the coil current into the coil according to the coil current value, and controls the microwave frequency at which the quantum current member operates according to the regulation microwave frequency, so that the quantum current measurement member performs the current measurement on the to-be-measured conductor and obtains the measured current value. Since the magnetic field direction of the first magnetic field generated by the measured current at the air gap during the current measurement is opposite to the magnetic field direction of the second magnetic field generated by the coil current at the air gap, the magnetic field at the air gap is near the zero point, that is, the magnetic induction intensity at the air gap approaches to zero. Accordingly, the measured current signal is weakened, a measurement range of the current measured by the quantum current measurement member is reduced, so that the precision of the obtained measured current value is improved, and the high-precision and wide-range current measurement requirements can be implemented.

Based on the FIG. 8, in an exemplary embodiment, as shown in FIG. 9, the above step S802 further includes the following steps S901 to S902.

S901: the coil current value is determined by the coil control circuit in the first control circuit according to the broadband current signal, and a coil current is circulated into the coil according to the coil current value.

The coil control circuit is configured to determine the coil current value according to the broadband current signal. In the embodiment, the current measurement device may receive the broadband current signal via the coil control circuit, and then determine the coil current value according to a current regulation formula. Subsequently, the coil control circuit is connected to the coil, and the coil current is circulated into the coil according to the coil current value.

S902: the regulation microwave frequency is determined by the frequency regulation circuit in the first control circuit according to the broadband current signal, and the microwave frequency at which the quantum current measurement member operates is controlled according to the regulation microwave frequency.

The frequency regulation circuit is configured to determine a regulation microwave frequency input into the quantum current measurement member according to the broadband current signal. In the embodiment, the current measurement device may receive the broadband current signal via the frequency regulation circuit, and perform a frequency analysis on the broadband current signal, and then determine the regulation microwave frequency from a result of the frequency analysis according to a preset frequency. Subsequently, the frequency regulation circuit is connected to the quantum current measurement member, and outputs the regulation microwave frequency to the quantum current measurement member, to control the microwave frequency at which the quantum current measurement member operates according to the regulation microwave frequency.

In feasible embodiment, amplification processing is performed on the regulation microwave frequency by a conditioning circuit in the first control circuit to obtain an amplified regulation microwave frequency, and the microwave frequency at which the quantum current measurement member operates is controlled according to the amplified regulation microwave frequency.

The conditioning circuit is configured to perform amplification processing on a signal. In the embodiment, the current measurement device may perform the amplification processing on the regulation microwave frequency via the conditioning circuit, and transmit the amplified regulation microwave frequency to the quantum current measurement member, so that the microwave frequency at which the quantum current measurement member operates can be controlled according to the amplified regulation microwave frequency.

In the embodiment, the current measurement device may determine the coil current value via the coil control circuit according to the broadband current signal, circulate the coil current into the coil according to the coil current value, determine the regulation microwave frequency via the frequency regulation circuit according to the broadband current signal, and control the microwave frequency at which the quantum current measurement member operates according to the regulation microwave frequency, so that the magnetic field direction of the first magnetic field generated by the measured current at the air gap is opposite to the magnetic field direction of the second magnetic field generated by the coil current at the air gap, thereby improving the precision of the measured current value obtained by the quantum current measurement member.

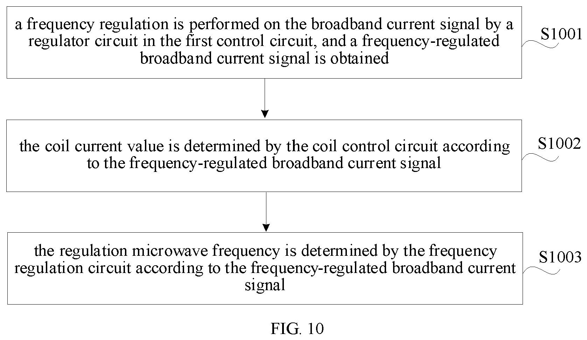

Based on the FIG. 8, in an exemplary embodiment, as shown in FIG. 10, the above step S802 further includes the following steps S1001 to S1003.

S1001: a frequency regulation is performed on the broadband current signal by a regulator circuit in the first control circuit, and a frequency-regulated broadband current signal is obtained.

The regulator circuit is configured to reduce a frequency of a broadband current signal to match a frequency range of the current measurement of the quantum current measurement member.

In the embodiment, the current measurement device may acquire the broadband current signal via the regulator circuit, and perform the frequency regulation on the broadband current signal to obtain the frequency-regulated broadband current signal.

S1002: the coil current value is determined by the coil control circuit according to the frequency-regulated broadband current signal.

In the embodiment, the current measurement device may acquire the frequency-regulated broadband current signal from the regulator circuit via the coil control circuit, and then determine the coil current value according to the frequency-regulated broadband current signal.

S1003: the regulation microwave frequency is determined by the frequency regulation circuit according to the frequency-regulated broadband current signal.

In the embodiment, the current measurement device may acquire the frequency-regulated broadband current signal from the regulator circuit via the frequency regulation circuit, and determine the regulation microwave frequency according to the frequency-regulated broadband current signal.

In the embodiment, the regulator circuit may acquire the broadband current signal, and perform the frequency regulation on the broadband current signal to obtain the frequency-regulated broadband current signal, in order to reduce a frequency corresponding to the broadband current signal. Subsequently, the coil control circuit may acquire the frequency-regulated broadband current signal via the regulator circuit, determine the coil current value according to the frequency-regulated broadband current signal. In addition, the frequency regulation circuit may acquire the frequency-regulated broadband current signal via the regulator circuit, and determine the regulation microwave frequency according to the frequency-regulated broadband current signal. Since the frequency-regulated broadband current signal can match the measurable frequency range of the quantum current measurement member, the precisions of the determined coil current value and regulation microwave frequency can be improved, thereby improving the precision of the measured current value obtained by the quantum current measurement member.

It should be appreciated that, although the steps in the flow charts related to the aforementioned embodiments are displayed in an order indicated by arrows, these steps are not definitely performed according to the order indicated by the arrows. Unless expressly stated in this specification, these steps are not performed in a strict order, and these steps may be performed in other orders. In addition, at least a part of steps in the flow charts involved in the aforementioned embodiments may include multiple steps or multiple phases. These steps or phases are not definitely performed at the same moment, but may be performed at different moments. These steps or phases are not definitely performed sequentially, but may be performed in turns or alternately with other steps or at least a part of steps or phases in other steps.

The technical features in the aforementioned embodiments may be combined in any manner. In order to make the description brief, all possible combinations of the technical features in the aforementioned embodiments are not described. However, as long as there is no contradiction between the combinations of the technical features, these combinations should be considered as the scope of the present invention.

The above-described embodiments only express several implementation modes of the present invention, and the descriptions are relatively specific and detailed, but should not be construed as limiting the scope of the present invention. It should be noted that, those of ordinary skill in the art can make several transformations and improvements without departing from the concept of the present invention, and these all fall within the protection scope of the present invention. Therefore, the protection scope of the present invention should be subject to the appended claims.

## Claims

1. A current measurement device, comprising a broadband current measurement probe, a quantum current measurement probe, and a first control circuit, the first control circuit being connected to the broadband current measurement probe, the quantum current measurement probe comprising a magnetic core, a coil provided on the magnetic core, and a quantum current measurement member provided in an air gap of the magnetic core, the first control circuit being further connected to the coil and the quantum current measurement member respectively; wherein

the broadband current measurement probe is configured to perform a current measurement on a to-be-measured conductor and obtain a broadband current signal;
the first control circuit is configured to determine a coil current value and a regulation microwave frequency according to the broadband current signal, circulate a coil current into the coil according to the coil current value, and control a microwave frequency at which the quantum current measurement member operates according to the regulation microwave frequency;
the quantum current measurement member is configured to perform a current measurement on the to-be-measured conductor and obtain a measured current value, wherein a magnetic field direction of a first magnetic field generated by the measured current at the air gap during the current measurement is opposite to a magnetic field direction of a second magnetic field generated by the coil current at the air gap.

2. The current measurement device according to claim 1, wherein the first control circuit comprises a coil control circuit and a frequency regulation circuit, the coil control circuit is connected to the broadband current measurement probe and the coil respectively, and the frequency regulation circuit is connected to the broadband current measurement probe and the quantum current measurement member respectively;

the coil control circuit is configured to determine the coil current value according to the broadband current signal, and circulate the coil current into the coil according to the coil current value; the frequency regulation circuit is configured to determine to the regulation microwave frequency according to the broadband current signal, and control the microwave frequency at which the quantum current measurement member operates according to the regulation microwave frequency.

3. The current measurement device according to claim 2, wherein the first control circuit further comprises a conditioning circuit connected between the frequency regulation circuit and the quantum current measurement member;
the conditioning circuit is configured to amplify the regulation microwave frequency, obtain an amplified regulation microwave frequency, and control the microwave frequency at which the quantum current measurement member operates according to the amplified regulation microwave frequency.

4. The current measurement device according to claim 3, wherein the conditioning circuit comprises a lock-in amplifier array, the lock-in amplifier array comprises a plurality of lock-in amplifiers, a first switch, and a second switch; a fixed end of the first switch is connected to the frequency regulation circuit, a movable end of the first switch is configured to be connected to an input terminal of each lock-in amplifier, a movable end of the second switch is configured to be connected to an output terminal of each lock-in amplifier, and a fixed end of the second switch is connected to the quantum current measurement member.

5. The current measurement device according to claim 2, wherein the first control circuit further comprises a regulator circuit, one terminal of the regulator circuit is connected to the broadband current measurement probe, and the other terminal of the regulator circuit is connected to the coil control circuit and the frequency regulation circuit respectively;

the regulator circuit is configured to perform a frequency regulation on the broadband current signal and obtain a frequency-regulated broadband current signal;
the coil control circuit is configured to determine the coil current value according to the frequency-regulated broadband current signal; and
the frequency regulation circuit is configured to determine the regulation microwave frequency according to the frequency-regulated broadband current signal.

6. The current measurement device according to any one of claims 1 to 5, wherein the first control circuit further comprises a current synthesis circuit which is connected to the coil control circuit and the conditioning circuit in the first control circuit respectively; and
the current synthesis circuit is configured to perform statistical processing on the coil current value and the measured current value, and obtain a target current value corresponding to the to-be-measured conductor.

7. The current measurement device according to claim 1, further comprising a second control circuit, the second control circuit comprising an energy supply circuit and a data processing circuit, both of which are connected to the first control circuit,

wherein the energy supply circuit is configured to supply power to the first control circuit; and
the data processing circuit is configured to acquire a target current value, and output current according to the target current value, wherein the target current value is obtained by performing, by the first control circuit, statistical processing on the coil current value and the measured current value.

8. A current measurement method, applied to the current measurement device of any one of claims 1 to 7, the method comprising:

performing (S801), by the broadband current measurement probe in the current measurement device, a current measurement on a to-be-measured conductor, and obtaining a broadband current signal;
determining (S802), by the first control circuit in the current measurement device, a coil current value and a regulation microwave frequency according to the broadband current signal, circulating a coil current into a coil according to the coil current value, and controlling a microwave frequency at which a quantum current measurement member operates according to the regulation microwave frequency; and

performing (S803), by the quantum current measurement member in the current measurement device, a current measurement on the to-be-measured conductor to obtain a measured current value, wherein a magnetic field direction of a first magnetic field generated by the measured current at an air gap during the current measurement is opposite to a magnetic field direction of a second magnetic field generated by the coil current at an air gap.

9. The method according to claim 8, wherein determining the coil current value and the regulation microwave frequency according to the broadband current signal, circulating the coil current into the coil according to the coil current value, and controlling the microwave frequency at which the quantum current measurement member operates according to the regulation microwave frequency comprises:

determining (S901), by the coil control circuit in the first control circuit, the coil current value according to the broadband current signal, and circulating the coil current into the coil according to the coil current value; and
determining (S902), by the frequency regulation circuit in the first control circuit, the regulation microwave frequency according to the broadband current signal, and controlling the microwave frequency at which the quantum current measurement member operates according to the regulation microwave frequency.

10. The method according to claim 9, wherein controlling the microwave frequency at which the quantum current measurement member operates according to the regulation microwave frequency comprises:
amplifying, by a conditioning circuit in the first control circuit, the regulation microwave frequency to obtain an amplified regulation microwave frequency, and controlling the microwave frequency at which the quantum current measurement member operates according to the amplified regulation microwave frequency.

11. The method according to claim 9, wherein determining the coil current value and the regulation microwave frequency according to the broadband current signal, circulating the coil current into the coil according to the coil current value, and controlling the microwave frequency at which the quantum current measurement member operates according to the regulation microwave frequency comprises:

performing (S1001), by a regulator circuit in the first control circuit, a frequency regulation on the broadband current signal, and obtaining a frequency-regulated broadband current signal;
determining (S1002), by the coil control circuit, the coil current value according to the frequency-regulated broadband current signal; and
determining (S1003), by the frequency regulation circuit, the regulation microwave frequency according to the frequency-regulated broadband current signal.

12. The method according to claim 8, further comprising:
performing, by a current synthesis circuit in the first control circuit, statistical processing on the coil current value and the measured current value, and obtaining the target current value corresponding to the to-be-measured conductor.

**Amended claims in accordance with Rule 137(2) EPC.**

1. A current measurement device, comprising a broadband current measurement probe, a quantum current measurement probe, and a first control circuit, the first control circuit being connected to the broadband current measurement probe, the quantum current measurement probe comprising a magnetic core, a coil provided on the magnetic core, and a quantum current measurement member provided in an air gap of the magnetic core, the first control circuit being further connected to the coil and the quantum current measurement member respectively; wherein

the broadband current measurement probe is configured to perform a current measurement on a to-be-measured conductor and obtain a broadband current signal;
the first control circuit is configured to determine a coil current value and a regulation microwave frequency according to the broadband current signal, circulate a coil current into the coil according to the coil current value, and control a microwave frequency at which the quantum current measurement member operates according to the regulation microwave frequency;
the quantum current measurement member is configured to perform a current measurement on the to-be-measured conductor and obtain a measured current value, wherein a magnetic field direction of a first magnetic field generated by the measured current at the air gap during the current measurement is opposite to a magnetic field direction of a second magnetic field generated by the coil current at the air gap;
**characterized in that** the first control circuit comprises a coil control circuit and a frequency regulation circuit, the coil control circuit is connected to the broadband current measurement probe and the coil respectively, and the frequency regulation circuit is connected to the broadband current measurement probe and the quantum current measurement member respectively;

the coil control circuit is configured to determine the coil current value according to the broadband current signal, and circulate the coil current into the coil according to the coil current value; the frequency regulation circuit is configured to determine the regulation microwave frequency according to the broadband current signal, and control the microwave frequency at which the quantum current measurement member operates according to the regulation microwave frequency.

2. The current measurement device according to claim 1, wherein the first control circuit further comprises a conditioning circuit connected between the frequency regulation circuit and the quantum current measurement member;

the conditioning circuit is configured to amplify the regulation microwave frequency, obtain an amplified regulation microwave frequency, and control the microwave frequency at which the quantum current measurement member operates according to the amplified regulation microwave frequency.

3. The current measurement device according to claim 2, wherein the conditioning circuit comprises a lock-in amplifier array, the lock-in amplifier array comprises a plurality of lock-in amplifiers, a first switch, and a second switch; a fixed end of the first switch is connected to the frequency regulation circuit, a movable end of the first switch is configured to be connected to an input terminal of each lock-in amplifier, a movable end of the second switch is configured to be connected to an output terminal of each lock-in amplifier, and a fixed end of the second switch is connected to the quantum current measurement member.

4. The current measurement device according to claim 1, wherein the first control circuit further comprises a regulator circuit, one terminal of the regulator circuit is connected to the broadband current measurement probe, and the other terminal of the regulator circuit is connected to the coil control circuit and the frequency regulation circuit respectively;

the regulator circuit is configured to perform a frequency regulation on the broadband current signal and obtain a frequency-regulated broadband current signal; the coil control circuit is configured to determine the coil current value according to the frequency-regulated broadband current signal; and

the frequency regulation circuit is configured to determine the regulation microwave frequency according to the frequency-regulated broadband current signal.

5. The current measurement device according to any one of claims 1 to 4, wherein the first control circuit further comprises a current synthesis circuit which is connected to the coil control circuit and the conditioning circuit in the first control circuit respectively; and

the current synthesis circuit is configured to perform statistical processing on the coil current value and the measured current value, and obtain a target current value corresponding to the to-be-measured conductor.

6. The current measurement device according to claim 1, further comprising a second control circuit, the second control circuit comprising an energy supply circuit and a data processing circuit, both of which are connected to the first control circuit,

wherein the energy supply circuit is configured to supply power to the first control circuit; and the data processing circuit is configured to acquire a target current value, and output current according to the target current value, wherein the target current value is obtained by performing, by the first control circuit, statistical processing on the coil current value and the measured current value.

7. A current measurement method, applied to the current measurement device of any one of claims 1 to 6, the method comprising:

performing (S801), by the broadband current measurement probe in the current measurement device, a current measurement on a to-be-measured conductor, and obtaining a broadband current signal; determining (S802), by the first control circuit in the current measurement device, a coil current value and a regulation microwave frequency according to the broadband current signal, circulating a coil current into the coil according to the coil current value, and controlling a microwave frequency at which the quantum current measurement member operates according to the regulation microwave frequency; and performing (S803), by the quantum current measurement member in the current measurement device, a current measurement on the to-be-measured conductor to obtain a measured current value, wherein a magnetic field direction of a first magnetic field generated by the measured current at an air gap during the current measurement is opposite to a magnetic field direction of a second magnetic field generated by the coil current at an air gap;

wherein determining the coil current value and the regulation microwave frequency according to the broadband current signal, circulating the coil current into the coil according to the coil current value, and controlling the microwave frequency at which the quantum current measurement member operates according to the regulation microwave frequency comprises:

determining (S901), by the coil control circuit in the first control circuit, the coil current value according to the broadband current signal, and circulating the coil current into the coil according to the coil current value; and

determining (S902), by the frequency regulation circuit in the first control circuit, the regulation microwave frequency according to the broadband current signal, and controlling the microwave frequency at which the quantum current measurement member operates according to the regulation microwave frequency.

8. The method according to claim 7, wherein controlling the microwave frequency at which the quantum current measurement member operates according to the regulation microwave frequency comprises: amplifying, by a conditioning circuit in the first control circuit, the regulation microwave frequency to obtain an amplified regulation microwave frequency, and controlling the microwave frequency at which the quantum current measurement member operates according to the amplified regulation microwave frequency.

9. The method according to claim 7, wherein determining the coil current value and the regulation microwave frequency according to the broadband current signal, circulating the coil current into the coil according to the coil current value, and controlling the microwave frequency at which the quantum current measurement member operates according to the regulation microwave frequency comprises:

performing (S1001), by a regulator circuit in the first control circuit, a frequency regulation on the broadband current signal, and obtaining a frequency-regulated broadband current signal;

determining (S1002), by the coil control circuit, the coil current value according to the frequency-regulated broadband current signal;

and

determining (S1003), by the frequency regulation circuit, the regulation microwave frequency according to the frequency-regulated broadband current signal.

10. The method according to claim 7, further comprising: performing, by a current synthesis circuit in the first control circuit, statistical processing on the coil current value and the measured current value, and obtaining the target current value corresponding to the to-be-measured conductor.

Current Measurement
Device

Coil
magnetic
core

To-be-
measured
conductor

$I$

Broadband
current
measurement
probe

Quantum
current
measurement
member

Quantum
current
measurement
probe

First control
circuit

FIG. 1

Current Measurement
Device

Coil
magnetic
core

To-be-
measured
conductor

$I$

Broadband
current
measurement
probe

Quantum
current
measurement
member

Quantum
current
measurement
probe

coil
control
circuit

$I_2$

$I_1$

frequency
regulation
circuit

First control circuit

FIG. 2

Current Measurement
Device

coil
magnetic
core

To-be-
measured
conductor

$I$

Broadband
current
measurement
probe

Quantum
current
measurement
member

Quantum
current
measurement
probe

coil
control
circuit

$I_2$

Frequency
amplification
circuit

$I_1$

frequency
regulation
circuit

First control circuit

FIG. 3

Input signal

lock-in
amplifier 1

Output signal

lock-in
amplifier 2

⋮

lock-in
amplifier n

Switch
S1

Switch
S2

FIG. 4

FIG.5

FIG. 6

FIG. 7

a broadband current measurement probe in a current measurement device performs a current measurement on a to-be-measured conductor, and obtains a broadband current signal ⁓ S801

a first control circuit in the current measurement device determines a coil current value and a regulation microwave frequency according to the broadband current signal, circulates a coil current into a coil according to the coil current value, and controls a microwave frequency at which a quantum current measurement member operates according to the regulation microwave frequency ⁓ S802

the quantum current measurement member in the current measurement device performs a current measurement on the to-be-measured conductor to obtain a measured current value; a magnetic field direction of a first magnetic field generated by the measured current at the air gap during the current measurement is opposite to a magnetic field direction of a second magnetic field generated by the coil current at the air gap ⁓ S803

FIG. 8

the coil current value is determined by the coil control circuit in the first control circuit according to the broadband current signal, and a coil current is circulated into the coil according to the coil current value ⁓ S901

the regulation microwave frequency is determined by the frequency regulation circuit in the first control circuit according to the broadband current signal, and the microwave frequency at which the quantum current measurement member operates is controlled according to the regulation microwave frequency ⁓ S902

FIG. 9

a frequency regulation is performed on the broadband current signal by a regulator circuit in the first control circuit, and a frequency-regulated broadband current signal is obtained

S1001

the coil current value is determined by the coil control circuit according to the frequency-regulated broadband current signal

S1002

the regulation microwave frequency is determined by the frequency regulation circuit according to the frequency-regulated broadband current signal

S1003

FIG. 10

Europäisches
Patentamt
European
Patent Office
Office européen
des brevets

## EUROPEAN SEARCH REPORT

**Application Number**

EP 25 18 0400

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 116 660 601 A (STATE GRID SMART GRID RES INSTITUTE CO LTD) 29 August 2023 (2023-08-29) | 1-3,5-12 | INV. G01R15/18 G01R15/20 |
| Y | * paragraphs [0037] - [0071]; figures 3, 4 * | 4 | |
| A | CN 105 807 117 A (SUZHOU RIGOL PREC ELECTRIC TECH CO LTD) 27 July 2016 (2016-07-27) * the whole document * | 1-12 | |
| Y | CN 116 660 604 A (ELECTRIC POWER SCIENCE RES INST OF STATE GRID ANHUI ELECTRIC POWER CO) 29 August 2023 (2023-08-29) | 4 | |
| A | * paragraphs [0028], [0040] * | 1-3,5-12 | |

**TECHNICAL FIELDS
SEARCHED (IPC)**

G01R

The present search report has been drawn up for all claims

| Place of search | Date of completion of the search | Examiner |
|---|---|---|
| Munich | 8 December 2025 | Jedlicska, István |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 18 0400

This annex lists the patent family members relating to the patent documents cited in the above-mentioned European search report.
The members are as contained in the European Patent Office EDP file on
The European Patent Office is in no way liable for these particulars which are merely given for the purpose of information.

08-12-2025

| Patent document cited in search report | | Publication date | Patent family member(s) | Publication date |
|---|---|---|---|---|
| CN 116660601 | A | 29-08-2023 | NONE | |
| CN 105807117 | A | 27-07-2016 | NONE | |
| CN 116660604 | A | 29-08-2023 | NONE | |

EPO FORM P0459

For more details about this annex : see Official Journal of the European Patent Office, No. 12/82